# EUROPEAN PATENT SPECIFICATION

(11) **EP 1 962 292 B1**
(45) Date of publication and mention of the grant of the patent: **24.04.2013**
(21) Application number: 08158094.6
(22) Date of filing: 18.07.2006
(51) Int. Cl.: G11C 27/02, H03K 17/13, H04L 27/156

(54) **Constant slope ramp circuits for sample-data circuits**
Schaltkreise mit konstanter Steigungsrampe für Probendatenschaltkreise
Circuits de rampe à pente constante pour circuits de données d'échantillon

(30) Priority: 19.07.2005 US 595605 P; 21.07.2005 US 595623 P; 16.06.2006 US 454275
(43) Date of publication of application: 27.08.2008
(62) Divisional of application: 06800132.0
(73) Proprietor: Cambridge Analog Technologies, Inc., Bedford, MA 01730 (US)
(72) Inventor: Lee, Hae-seung, Bedford, MA 01730 (US)
(74) Representative: Bergmeier, Werner

(56) References cited:
- WO-A1-93/05598
- US-A- 4 800 333
- US-B1- 6 556 072

## Description

### FIELD OF THE PRESENT INVENTION

The present invention relates generally to sample data circuits and, more particularly, to sample data circuits that include constant slope ramp circuits.

### BACKGROUND OF THE PRESENT INVENTION

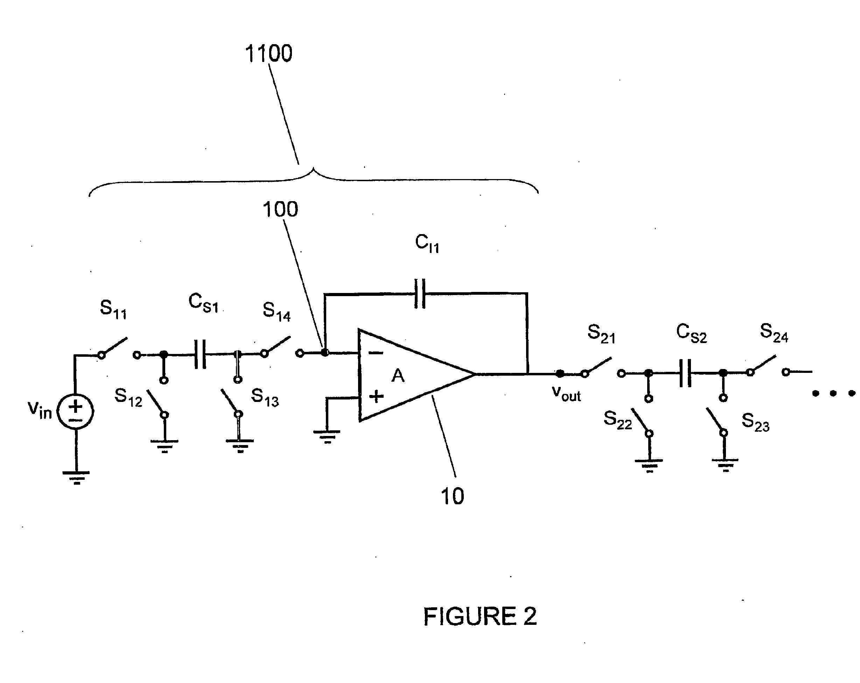

Most sample-data analog circuits such as switched-capacitor filters, analog-to-digital converters, and delta-sigma modulators require operational amplifiers to process the signal. Consider a switched-capacitor integrator example shown in Figure 2. First, the switches **S₁₁** and **S₁₃** are closed so that the input voltage vᵢₙ is sampled on the sampling capacitor **C_{S1}.** Next, the switches **S₁₁** and **S₁₃** are opened and **S₁₂** and **S₁₄** are closed. This operation transfers the charge in the sampling capacitor **C_{S1}** to the integrating capacitor **C_{I1}.** The output voltage, **vₒᵤₜ,** of a first integrator **1100** is typically sampled by another sample-data circuit, for example, another switched-capacitor integrator. In the circuit shown in Figure 2, the circuit consisting of switches **S₂₁, S₂₂, S₂₃, S₂₄,** and a second sampling capacitor **C_{S2}** comprise a part of the second switched-capacitor integrator. The output voltage, **vₒᵤₜ,** of the first integrator **10** is sampled on the second sampling capacitor **C_{S2}** by closing switches **S₂₁** and **S₂₃.**

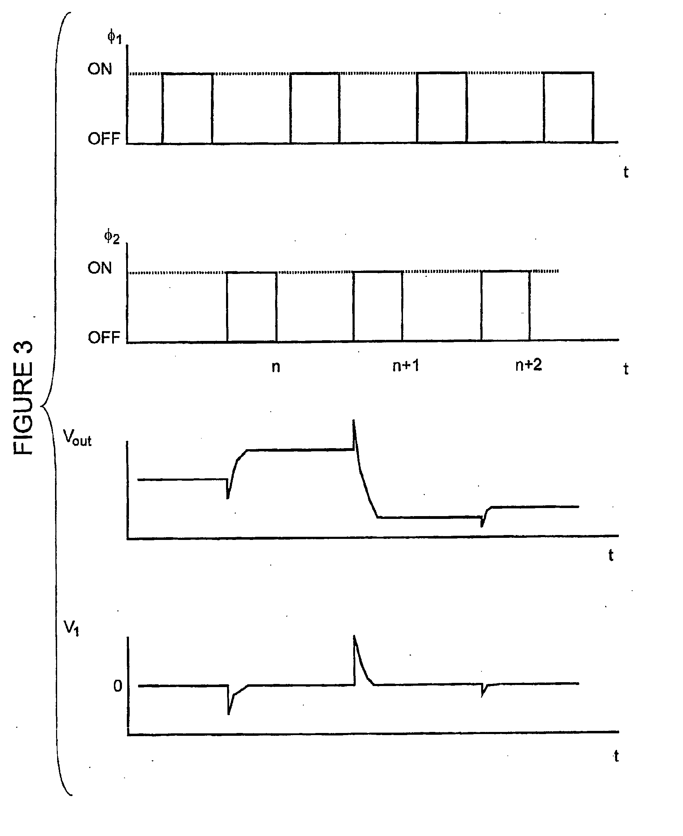

An example of a timing diagram is shown in Figure 3. The clock signal has two non-overlapping phases Φ₁ and Φ₂. The phase Φ₁ is applied to switches **S₁₁, S₁₃, S₂₁,** and **S₂₃,** and phase Φ₂ is applied to switches **S₁₂, S₁₄, S₂₂,** and **S₂₄.** With this timing, the circuit performs non-inverting discrete integration with full clock delay. The waveforms at the output of the integrator, **vₒᵤₜ,** and at the virtual ground node **100, v₁,** are also shown in Figure 3. Different clock phasing arrangements yield different responses from the integrator. For example, if Φ₁ is applied to switches **S₁₁, S₁₃, S₂₂,** and **S₂₄,** and phase Φ ₁ is applied to switches **S₁₂, S₁₄, S₂₁,** and **S₂₃,** the circuit performs non-inverting integration with half-clock delay.

For an accurate integration of the input signal, **v₁** must be driven as close to ground as possible. In order to accomplish this, the operational amplifier must provide sufficient open-loop gain and low noise. In addition, for fast operation, the operational amplifier 10 of Figure 2 must settle fast.

In Figure 3, the voltage **v₁** is shown to settle back to ground after a disturbance when the sampling capacitor **C_{S1}** is switched to Node **100** by closing **S₁₂** and **S₁₄.** In addition to high open-loop gain and fast settling time, operational amplifiers must provide large output swing for high dynamic range. As the technology scales, it becomes increasingly difficult to achieve these characteristics from operational amplifiers. The primary factors that make the operational amplifier design difficult are low power supply voltages and low device gain.

As noted above, accurate output voltage can be obtained if Node **100** in Figure 2 is maintained precisely at ground. However, in sample-data circuits, the only point of time accurate output voltage is required is at the instant the output voltage is sampled by another sampling circuit. Thus, it is not necessary to maintain the voltage at Node 100 at ground all the time.

It is further noted that delays in the detectors of sample-data circuits may cause errors in the operation thereof. Moreover, it is noted that performance parameters such as speed, accuracy, and power consumption of sample-data circuits depend upon the design of zero crossing detectors.

Therefore, it is desirable to provide a sample-data circuit that maintains the proper level at the virtual ground node at the instant the output voltage is sampled by another sampling circuit, substantially eliminates the errors caused by delays, and optimizes the performance parameters such as speed, accuracy, and power consumption of the sample-data circuit.

Moreover, it is desirable to provide a sample-data circuit that maintains the proper level at the virtual ground node at the instant the output voltage is sampled by another sampling circuit and provides differential signal paths for sample-data circuits, substantially eliminates the errors caused by delays, and optimizes the performance parameters such as speed, accuracy, and power consumption of the sample-data circuit.

Furthermore, it is desirable to provide a sample-data circuit that reduces the effect of power supply, substrate, and common-mode noise by symmetric differential signal processing, substantially eliminates the errors caused by delays, and optimizes the performance parameters such as speed, accuracy, and power consumption of the sample-data circuit.

Also, it is desirable to provide a sample-data circuit that increases the signal range by incorporating differential signal paths, substantially eliminates the errors caused by delays, and optimizes the performance parameters such as speed, accuracy, and power consumption of the sample-data circuit.

US 4 800 333 discloses an electronic energy consumption measuring circuit capable of being fabricated on a single integrated circuit chip and which employs a switched-capacitor integrator for integrating the product of first and second voltages which are proportional, respectively, to load voltage and current in an electrical system to provide a measure of the energy being consumed, and a hysteresis comparator for converting the integrator output into a pulse train wherein each pulse represents a predetermined amount of energy. The output pulses may be accumulated and displayed to provide an indication of total energy consumed. A divider at the hysteresis comparator output enables the capacitor ratio in the switched-capacitor integrator to be reduced substantially so that the capacitor values are approximately the same order of magnitude. This reduces the chip area necessary for fabricating the capacitors and improves the matching between the capacitors, thereby affording higher integration accuracy.

### SUMMARY OF THE PRESENT INVENTION

The present invention concerns a zero-crossing detector based circuit comprising the features recited in claim 1. Embodiments of the invention are recited in the dependent claims.

### BRIEF DESCRIPTION OF THE DRAWINGS

The present invention may take form in various components and arrangements of components, and in various steps and arrangements of steps. The drawings are ony for purposes of illustrating a preferred embodiment and are not to be construed as limiting the present invention, wherein:

Figure 1 illustrates a zero-crossing detector;

Figure 2 illustrates a switched-capacitor integrator;

Figure 3 illustrates a timing diagram for the switched-capacitor integrator of Figure 2;

Figure 4 illustrates a non-inverting integrator according to the concepts of the present invention;

Figure 5 illustrates a timing diagram for the non-inverting integrator of Figure 4;

Figure 6 illustrates a non-inverting integrator with a waveform generator being a current source according to the concepts of the present invention;

Figure 7 illustrates another non-inverting integrator according to the concepts of the present invention;

Figure 8 illustrates a timing diagram for the non-inverting integrator of Figure 7;

Figure 9 illustrates another non-inverting integrator according to the concepts of the present invention;

Figure 10 illustrates another non-inverting integrator according to the concepts of the present invention;

Figure 11 illustrates a timing diagram for the non-inverting integrator of Figure 10;

Figure 12 illustrates another non-inverting integrator according to the concepts of the present invention;

Figure 13 illustrates another non-inverting integrator according to the concepts of the present invention;

Figure 14 illustrates a timing diagram for the non-inverting integrator of Figure 13;

Figure 15 illustrates one embodiment of a sample-data circuit according to the concepts of the present invention;

Figure 16 illustrates another embodiment of a sample-data circuit according to the concepts of the present invention;

Figure 17 illustrates another embodiment of a sample-data circuit according to the concepts of the present invention;

Figure 18 illustrates another embodiment of a sample-data circuit according to the concepts of the present invention;

Figure 19 illustrates another embodiment of a sample-data circuit according to the concepts of the present invention;

Figure 20 illustrates an embodiment a continuous-time voltage comparator for a sample-data circuit according to the concepts of the present invention;

Figure 21 illustrates another embodiment a continuous-time voltage comparator for a sample-data circuit according to the concepts of the present invention;

Figure 22 illustrates another embodiment a continuous-time voltage comparator for a sample-data circuit according to the concepts of the present invention;

Figure 23 illustrates another embodiment a continuous-time voltage comparator for a sample-data circuit according to the concepts of the present invention;

Figure 24 illustrates another embodiment a continuous-time voltage comparator for a sample-data circuit according to the concepts of the present invention;

Figure 25 illustrates another embodiment a continuous-time voltage comparator for a sample-data circuit according to the concepts of the present invention;

Figure 26 illustrates another embodiment a continuous-time voltage comparator for a sample-data circuit according to the concepts of the present invention;

Figure 27 illustrates another embodiment a continuous-time voltage comparator for a sample-data circuit according to the concepts of the present invention; and

Figure 28 illustrates another embodiment a continuous-time voltage comparator for a sample-data circuit according to the concepts of the present invention.

### DETAILED DESCRIPTION OF THE PRESENT INVENTION

The present invention will be described in connection with preferred embodiments; however, it will be understood that there is no intent to limit the present invention to the embodiments described herein. On the contrary, the intent is to cover all alternatives, modifications, and equivalents as may be included within the spirit and scope of the present invention, as defined by the appended claims.

For a general understanding of the present invention, reference is made to the drawings. In the drawings, like reference have been used throughout to designate identical or equivalent elements. It is also noted that the various drawings illustrating the present invention may not have been drawn to scale and that certain regions may have been purposely drawn disproportionately so that the features and concepts of the present invention could be properly illustrated.

It is noted that, in the various Figures, the earth symbol indicates the system's common-mode voltage. For example, in a system with 2.5 V and -2.5 V power supplies, the system's common-mode voltage may be at ground. In a system with a single 2.5 power supply, the system's common-mode voltage may be at 1.25 V.

As noted above, accurate output voltage can be obtained if Node 100 in Figure 2 is maintained precisely at ground. However, in sample-data circuits, the only point of time accurate output voltage is required is at the instant the output voltage is sampled by another sampling circuit. Thus, it is not necessary to maintain the voltage at Node 100 at ground all the time.

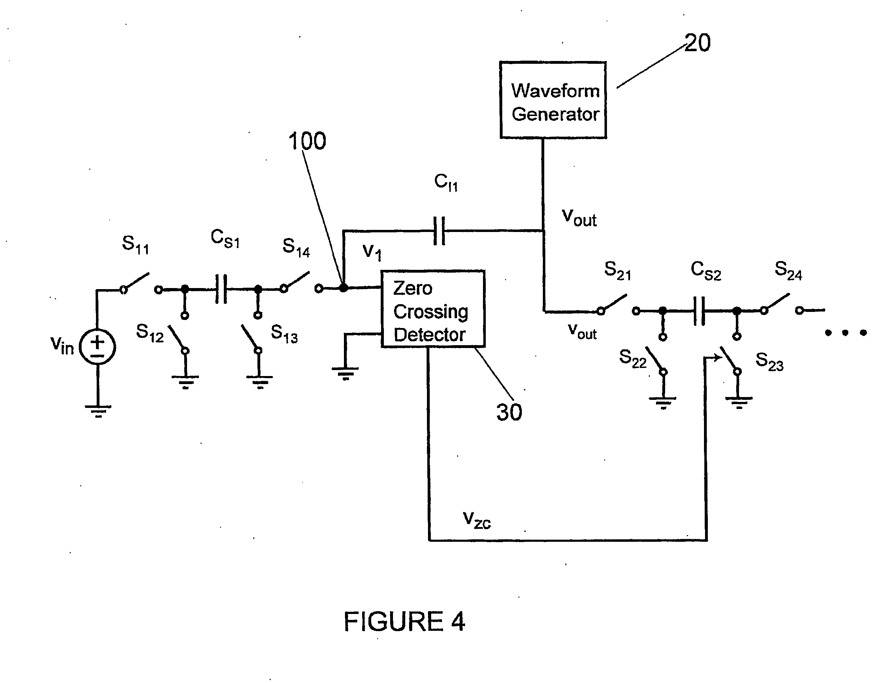

Figure 4 illustrates a non-inverting integrator according to the concepts of the present invention. More specifically, as an example, a non-inverting integrator with half-clock delay is illustrated in Figure 4.

As illustrated in Figure 4, a clock phase Φ₁ is applied to switches **S₁₁, S₁₃, S₂₂,** and **S₂₄,** and another phase Φ₂ is applied to switches **S₁₂, S₁₄,** and **S₂₁.** A zero crossing detector **30** is used to detect the point of time at which Node **100** crosses ground. The switch **S₂₃** is controlled by the output of the zero crossing detector **30.** The output of the zero crossing detector **30** is used to determine the time point to take the sample of the output voltage **vₒᵤₜ.** A waveform generator **20** generates a voltage waveform as the output voltage **vₒᵤₜ** in such way the voltage at Node **100** crosses zero if the charge in capacitors **C_{S1}** and **C_{I1}** is within a normal operating range.

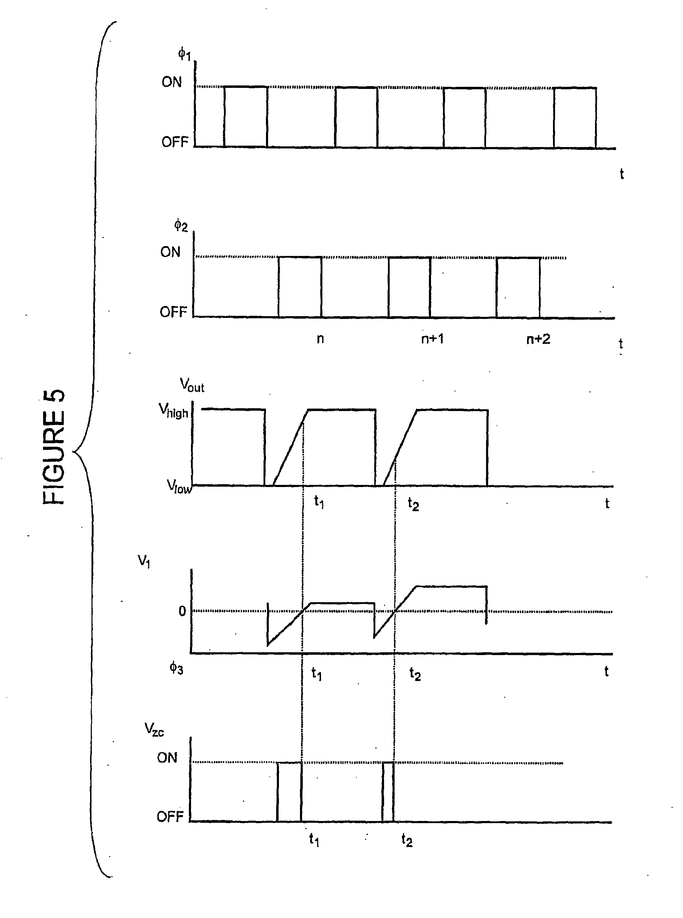

In the timing diagram shown in Figure 5, the waveform generated by the waveform generator **20** is shown as a ramp. When **v₁,** the voltage at Node **100,** crosses zero at time **t₁,** the output **V_{zc}** of the zero crossing detector **30** goes low, turning the switch **S₂₃** OFF. At that instant, the output voltage **vₒᵤₜ** is sampled on **C_{S2}.**

Since **v₁** is very close to zero when the sample of **v₂** is taken, an accurate output voltage is sampled on **C_{S2}.** A similar operation repeats during the next clock cycle, and the sample of the output voltage is taken at time **t₂.**

It is noted that the zero crossing detector **30** may optionally have an overflow detection feature that determines when the charge in capacitors **C_{S1}** and **C_{I1}** is outside the normal range of operation. It can be implemented by a logic circuit that makes the output **v_{zc}** of the zero-crossing detector **30** to go low when Φ₂ goes low. In the event v₁ fails to cross zero, the sample is taken on the falling edge of Φ₂. At the same time, the logic circuit produces a flag indicating overflow.

In the embodiment described above and in the various embodiments described below, a zero crossing detector is utilized in lieu of a comparator. Typically, a comparator is designed to compare two arbitrary input voltages. A comparator may be implemented as cascaded amplifiers, a regenerative latch, or a combination of both. A comparator may be used to detect a zero voltage level or a predetermined voltage level crossing.

It is noted that the input waveform of the various described embodiments is not arbitrary, but deterministic and repetitive. Thus, the various described embodiments determine the instant the zero voltage level or the predetermined voltage level is crossed than relative amplitudes of the input signals. For such a deterministic input, a zero crossing detector is more efficient.

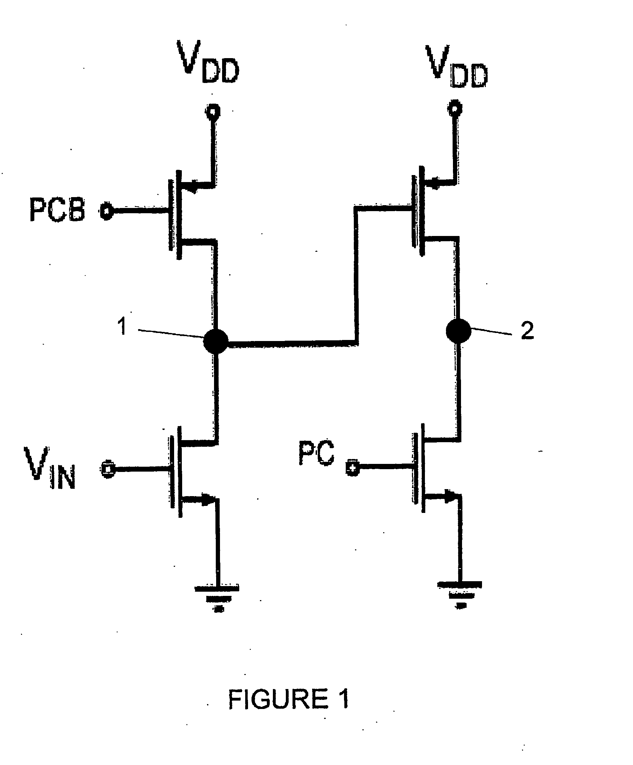

An example of a zero-crossing detector for the detection of a positive-going input signal is shown in Figure 1. Initially, node **1** and node **2** are precharged to **V_{DD}** and ground, respectively. The ramp input voltage **V_{IN}** is applied according to the zero crossing circuit. At the time the input node crosses the threshold, node 1 is discharged rapidly, and node **2** is pulled up to **V_{DD}.** Since the zero crossing detector in Figure 1 is a dynamic circuit, there is no DC power consumption, allowing extremely low power and fast operation. For the detection of zero-crossing of a negative-going signal, a complementary circuit with a PMOS input transistor can be utilized.

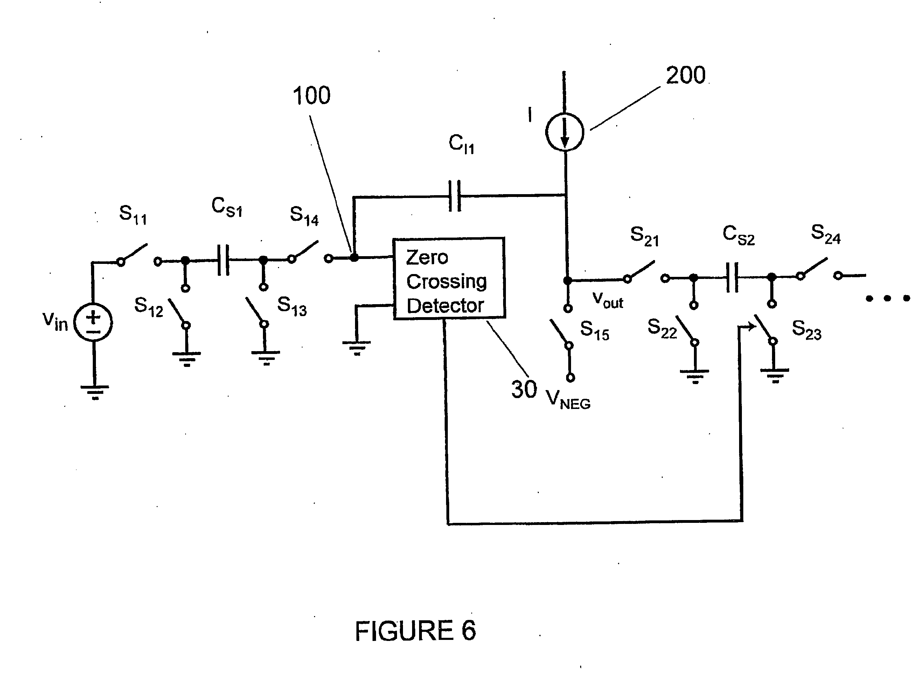

As illustrated in Figure 6, the non-inverting integrator includes a waveform generator which is a current source **200.** As illustrated in Figure 6, a clock phase Φ₁ is applied to switches **S₁₁, S₁₃, S₂₂,** and **S₂₄,** and another phase Φ₂ is applied to switches **S₁₂, S₁₄,** and **S₂₁.** A zero crossing detector **30** is used to detect the point of time at which Node **100** crosses ground. The switch **S₂₃** is controlled by the output of the zero crossing detector **30.** The output of the zero crossing detector **30** is used to determine the time point to take the sample of the output voltage **vₒᵤₜ.**

The current source **200** charges the capacitors **C_{S2}** and the series connected **C_{S1}** and **C_{I1},** generating a ramp. At the start of Φ₂, the output is briefly shorted to a known voltage V_{NEG}, the value of which is chosen to ensure the voltage v₁ at Node **100** crosses zero with signals in the normal operating range.

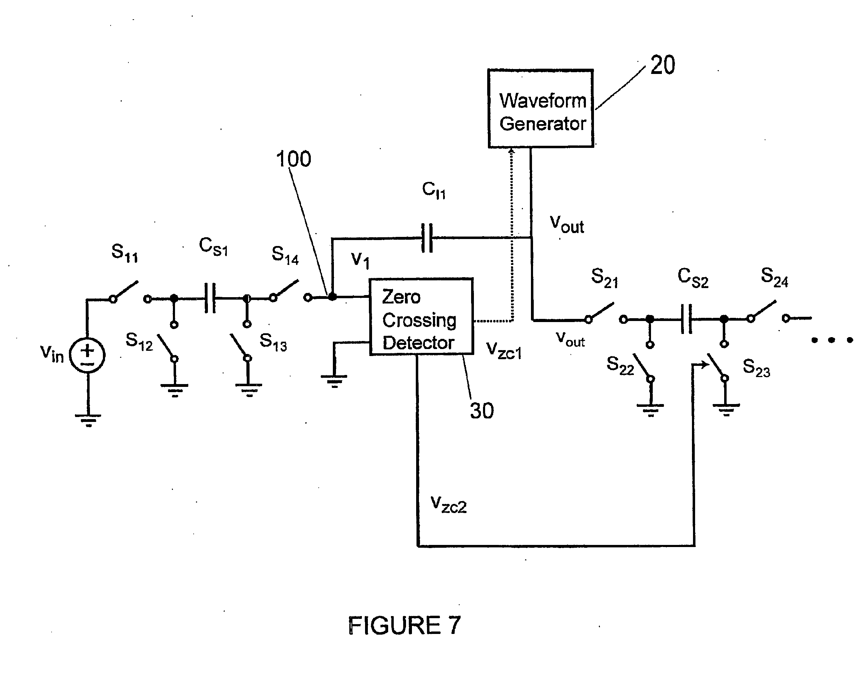

As illustrated in Figure 7, the non-inverting integrator includes a waveform generator **20** that produces, preferably, a plurality of segments in the waveform with varying rate of change of the output voltage. The first segment may be controlled so as to have the highest rate of change, with subsequent segments having progressively lower rate of change. The detection of zero crossing by the zero crossing detector 30 causes the waveform to advance to the next segment. An output signal **V_{zc2}** of the zero crossing detector 30 remains high until the zero crossing is detected in the last segment of the waveform.

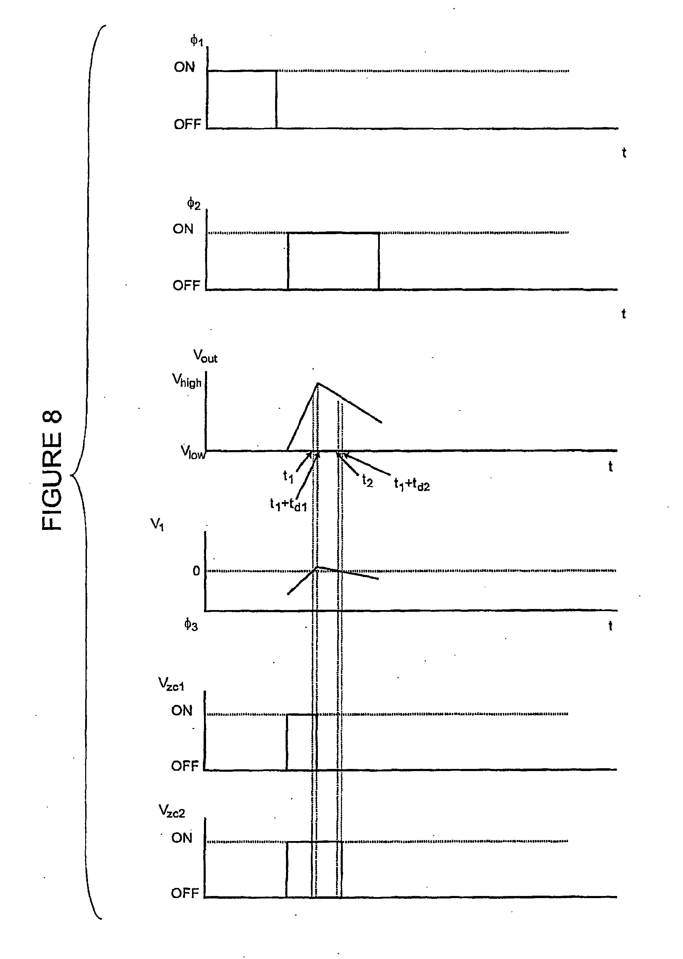

One clock cycle of the timing diagram is shown in Figure 8. At the start of Φ₂, the waveform generator **20** produces an up ramp. The voltage **v₁** is shown to cross zero at time **t₁.** One output, **v_{zc1},** of the zero crossing detector **30** changes its state after a finite delay **t_{d1}.**

The delay **t_{d1}** represents finite delay of a typical zero crossing detector **30.** This change of state advances the waveform to the next segment.

Due to the delay **t_{d1}** of the zero crossing detector **30,** the voltage **v₁** overshoots by a small amount above ground. The second segment of the waveform generator is a down ramp to permit another zero crossing at time **t₂.** After a second delay **t_{d2},** the output **V_{zc2}** of the zero crossing detector **30** goes low, causing the switch **S₂₃** to turn OFF, locking the sample of the output voltage **vₒᵤₜ.**

The delay **t_{d2}** of the second zero crossing is not necessarily the same as the delay associated with the first zero crossing **t_{d1}.** The delay **t_{d2}** contributes a small overshoot to the sampled output voltage. The effect of the overshoot can be shown to be constant offset in the sampled charge. In most sample-data circuits, such constant offset is of little issue.

The zero crossing detector **30** preferably becomes more accurate in detecting the zero crossing as the segments of the waveform advances. The first detection being a coarse detection, it doesn't have to be very accurate. Therefore, the detection can be made faster with less accuracy. The last zero crossing detection in a given cycle determines the accuracy of the output voltage. For this reason, the last zero crossing detection must be the most accurate.

The accuracy, speed, and the power consumption can be appropriately traded among progressive zero crossing detections for the optimum overall performance. For example, the first detection is made less accurately and noisier but is made faster (shorter delay) and lower power. The last detection is made more accurately and quieter while consuming more power or being slower (longer delay).

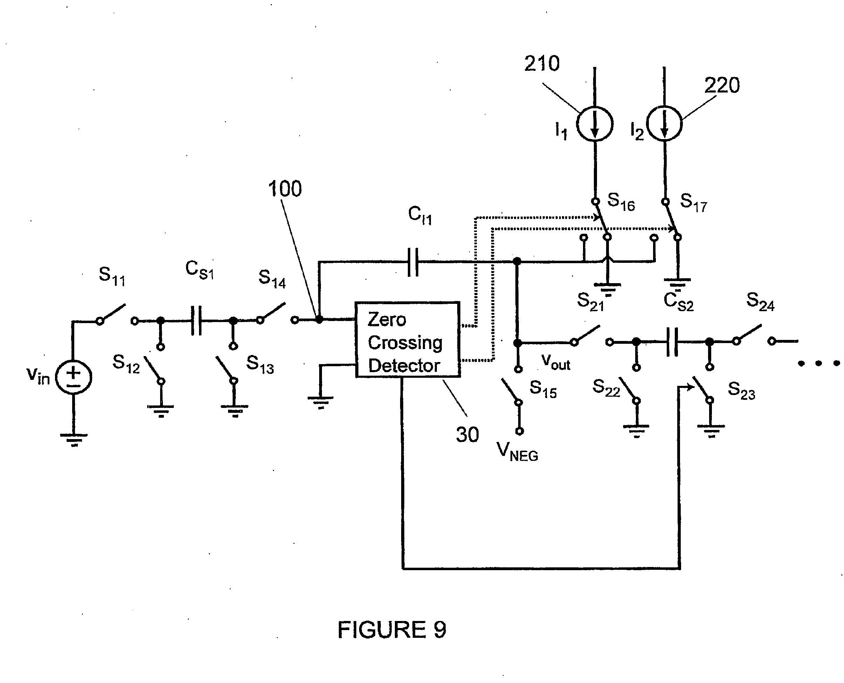

An example of a two-segment waveform generator constructed of two current sources (**210** and **220**) is shown in Figure 9. As illustrated in Figure 9, a clock phase Φ₁ is applied to switches **S₁₁, S₁₃, S₂₂,** and **S₂₄,** and another phase Φ₂ is applied to switches **S₁₂, S₁₄,** and **S₂₁.** A zero crossing detector **30** is used to detect the point of time at which Node **100** crosses ground. The switch **S₂₃** is controlled by the output of the zero crossing detector **30.** The output of the zero crossing detector **30** is used to determine the time point to take the sample of the output voltage **Vₒᵤₜ.**

Current sources **210** and **220** charge the capacitors **C_{S2}** and the series connected **C_{S1}** and **C_{I1}** generating two segments of a ramp waveform. At the start of Φ₂, the output is briefly shorted to a known voltage **V_{NEG},** the value of which is chosen to ensure the voltage v₁ crosses zero with signals in the normal operating range. During the first segment, the current source 210 is directed to the output, while during the second segment, the current source 220 is directed to the output, generating two different slopes of ramp.

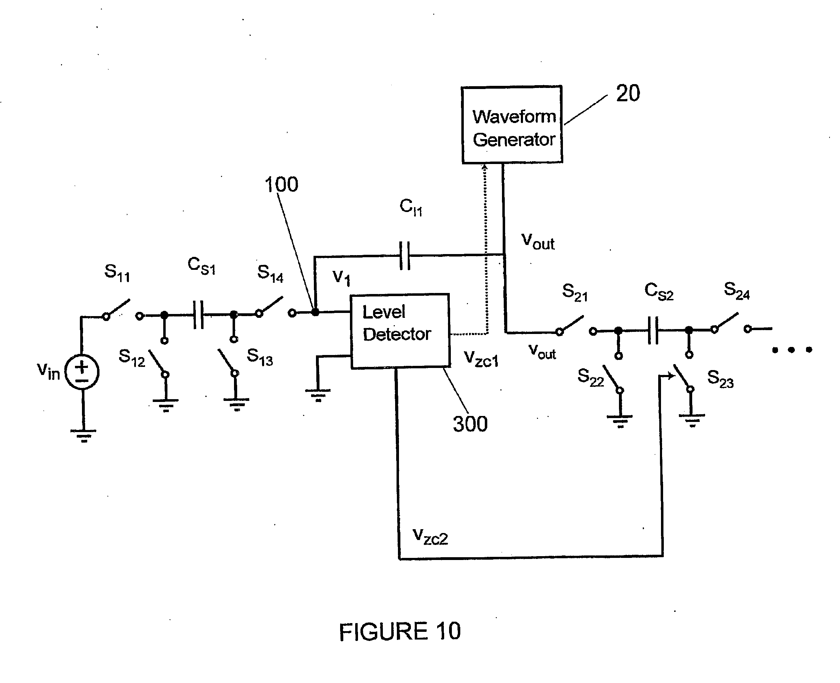

As illustrated in Figure 10, the non-inverting integrator includes a level crossing detector **300** having plurality of thresholds. As illustrated in Figure 10, a clock phase Φ₁ is applied to switches **S₁₁, S₁₃, S₂₂,** and **S₂₄,** and another phase Φ₂ is applied to switches **S₁₂, S₁₄,** and **S₂₁.** A level crossing detector **300** is used to detect the point of time at which Node **100** crosses one of plurality of predetermined levels as discussed below. The switch **S₂₃** is controlled by the output of the level crossing detector **300.** The output of the level crossing detector **300** is used to determine the time point to take the sample of the output voltage **vₒᵤₜ.**

The thresholds are predetermined voltage levels. The thresholds of the level crossing detector **300** can be adjusted to minimize overshoot.

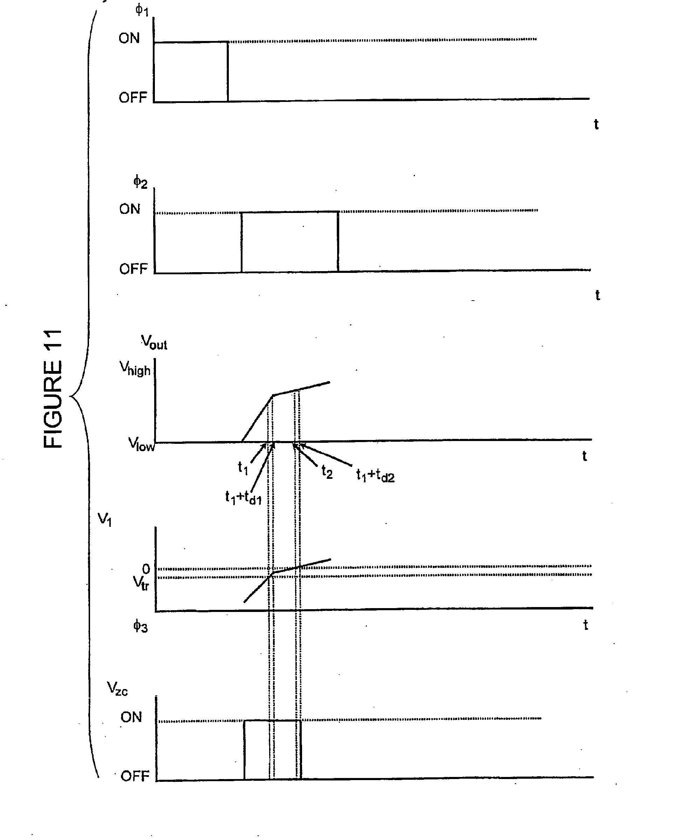

For example, the threshold for the first detection may be made negative by a slightly smaller amount than the expected overshoot in the first segment. This minimizes the ramp-down time in the second segment. Also, the threshold for the second segment may be made more positive by the amount of the overshoot in the second segment in order to cancel the effect of the overshoot. Alternatively, the threshold for the first segment may be made more negative than the expected overshoot during the first segment. This permits the second segment to be a positive ramp rather than a negative ramp as shown in Figure 11.

It is advantageous to make the detection during the last segment to be the most accurate detection. The accuracy of the detection during the last segment is made higher than during other segments. This can be achieved by making the delay longer or making the power consumption higher during the last segment.

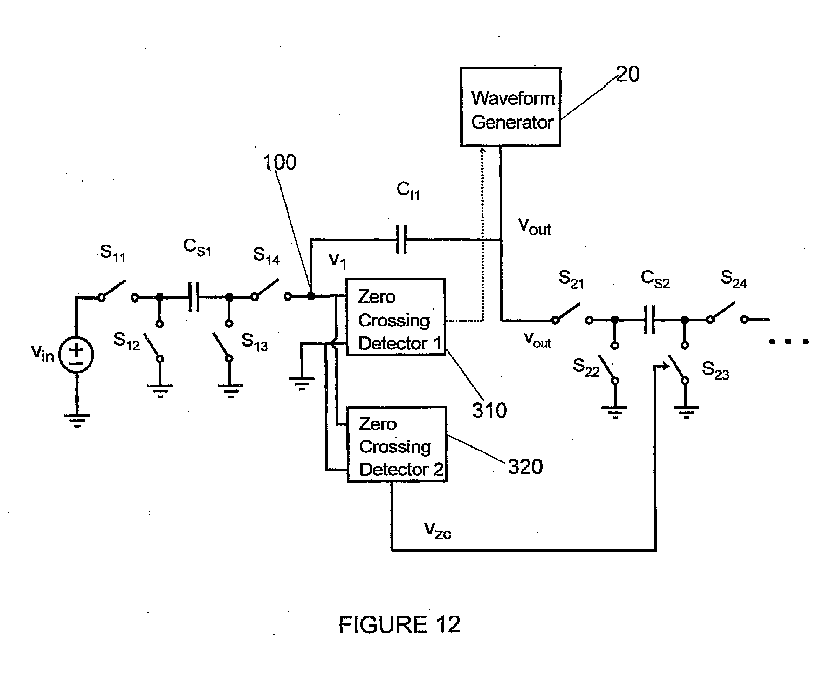

As illustrated in Figure 12, the non-inverting integrator includes a level crossing detector having two zero-crossing detectors, Zero Crossing Detector 1 **(310)** and Zero Crossing Detector 2 (**320**). As illustrated in Figure 12, a clock phase Φ₁ is applied to switches **S₁₁, S₁₃, S₂₂,** and **S₂₄,** and another phase Φ₂ is applied to switches **S₁₂, S₁₄,** and **S₂₁.** Zero Crossing Detector 1 (**310**) and Zero Crossing Detector 2 (**320**) are used to detect the point of time at which Node **100** crosses one of plurality of predetermined levels as discussed below. The switch **S₂₃** is controlled by the output of the Zero Crossing Detector 2 **(320).** The output of the Zero Crossing Detector 2 **(320)** is used to determine the time point to take the sample of the output voltage **vₒᵤₜ**.

The thresholds of the Zero Crossing Detector 1 (310) and Zero Crossing Detector 2 **(320)** are selected to minimize overshoot. For example, the threshold for Zero Crossing Detector 1 **(310)** may be made negative by a slightly smaller amount than the expected overshoot in the first segment. This minimizes the ramp-down time in the second segment. Also, the threshold for Zero Crossing Detector 2 **(320)** may be made more positive by the amount of the overshoot in the second segment in order to cancel the effect of the overshoot. Alternatively, the threshold for Zero Crossing Detector 1 (310) may be made more negative than the expected overshoot during the first segment. This permits Zero Crossing Detector 2 **(320)** to be a positive ramp rather than a negative ramp.

In other words, Zero Crossing Detector 1 **(310)** makes a coarse detection, whereas Zero Crossing Detector 2 **(320)** makes a fine detection. Thus, it is advantageous to make Zero Crossing Detector 2 **(320)** to have a higher accuracy.

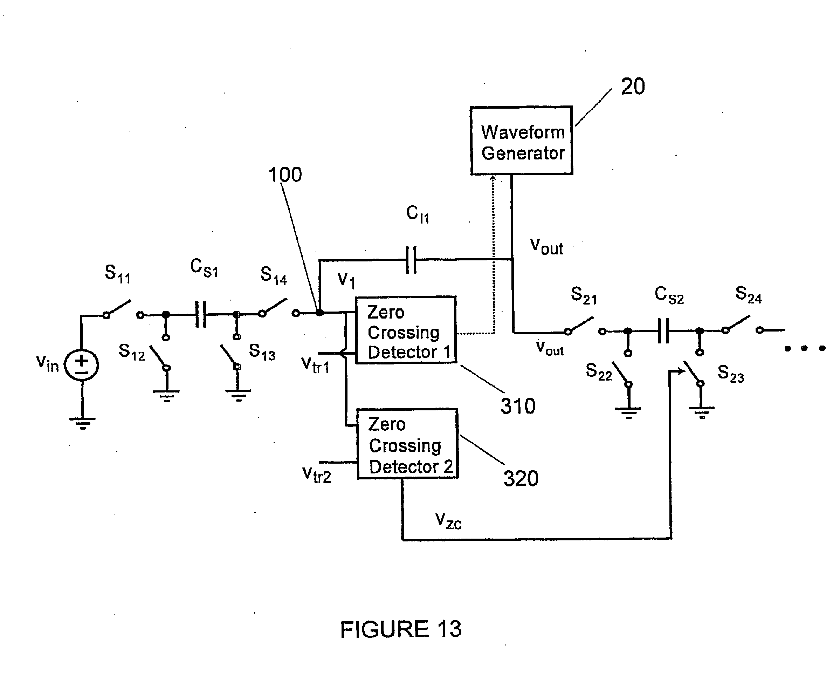

As illustrated in Figure 13, the non-inverting integrator includes a level crossing detector having two zero-crossing detectors, Zero Crossing Detector 1 (310) and Zero Crossing Detector 2 **(320).** As illustrated in Figure 13, a clock phase Φ₁ is applied to switches **S₁₁, S₁₃, S₂₂,** and **S₂₄,** and another phase **Φ**₂ is applied to switches **S₁₂, S₁₄,** and **S₂₁.** Zero Crossing Detector 1 **(310)** and Zero Crossing Detector 2 **(320)** are used to detect the point of time at which Node **100** crosses one of plurality of predetermined levels as discussed below. The switch **S₂₃** is controlled by the output of the Zero Crossing Detector 2 (**320**). The output of the Zero Crossing Detector 2 **(320)** is used to determine the time point to take the sample of the output voltage **vₒᵤₜ.**

Both detectors, Zero Crossing Detector 1 **(310)** and Zero Crossing Detector 2 **(320),** have nominally zero thresholds. The detection thresholds are determined by voltages **Vₜᵣ₁** and **Vₜᵣ₂** applied to the inputs of Zero Crossing Detector 1 **(310)** and Zero Crossing Detector 2 (**320**), respectively. Zero Crossing Detector 1 **(310)** makes a coarse detection, whereas Zero Crossing Detector 2 **(320)** makes a fine detection. Thus, it is advantageous to make Zero Crossing Detector 2 **(320)** to have a higher accuracy.

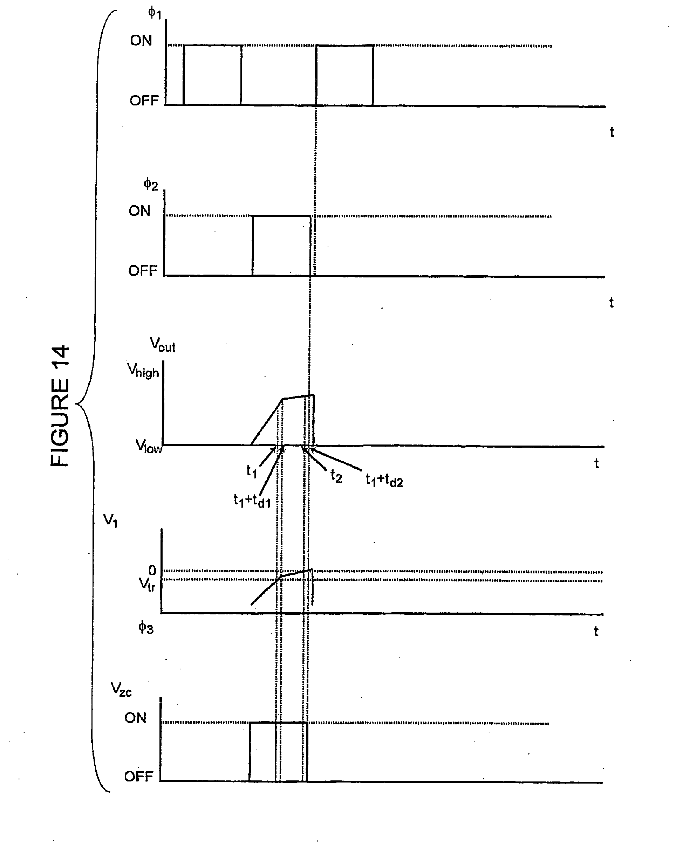

It is noted that the above-described embodiment may operate as a self-timed system. In this configuration, Rather than supplying constant frequency clock phases Φ ₁ and Φ₂, the clock phases are derived from the outputs of Zero Crossing Detector 1 **(310)** and Zero Crossing Detector 2 **(320).** Figure 14 illustrates a self-timed operation.

As illustrated in Figure 14, the end of the phase Φ₂ is defined by the output of the detection during the last segment. The beginning of the clock phase Φ₁ is defined by a short delay, such as logic delays, after the end of Φ₂. The short delay is generally necessary to ensure non-overlapping clock phases. The end of the clock phase Φ₁ is determined by the zero crossing detection of the previous stage or the following stage in the similar manner.

It is noted that the various embodiments described above can be utilized in a pipeline analog-to-digital converter, an algorithmic analog-to-digital converter, a switched-capacitor amplifier, a delta-sigma modulator, or a self-timed algorithmic analog-to-digital converter.

It is further noted that the various embodiments described above have signal paths that are single-ended, thus, it is desirable to provide differential signal paths. The various embodiments described below provide differential signal paths.

As noted above, it is desirable to substantially eliminate the errors associated with time delays. One solution to substantially eliminate the errors associated with time delays is to have the error in a form that can be easily managed.

For example, if a waveform generator produces a ramp whose slope is constant in each segment of the ramp, the error associated with the delays becomes a constant DC offset. A constant DC offset can be easily compensated or tolerated in most systems. However, simple waveform generators, for example, the one shown in Fig. 6, produce non-linear ramp signals. The nonlinearity in the ramp slope of the conventional sample-data circuits causes nonlinearity in the resulting sample-data circuit error. The non-linear error is difficult to compensate.

To address this problem, the present invention provides a circuit that generates ramp waveforms with plurality of linear segments of varying slopes whereby the slope is independent of the output voltage and load conditions in each segment of the ramp. By generating ramp waveforms with plurality of linear segments of varying slopes, the error is a plurality of constant DC offsets that can easily compensated for or tolerated.

Furthermore, to address this problem, the present invention provides a circuit that generates ramp waveforms with plurality of linear segments of varying slopes whereby the advancement to the next segment is controlled by an output of a zero crossing detector.

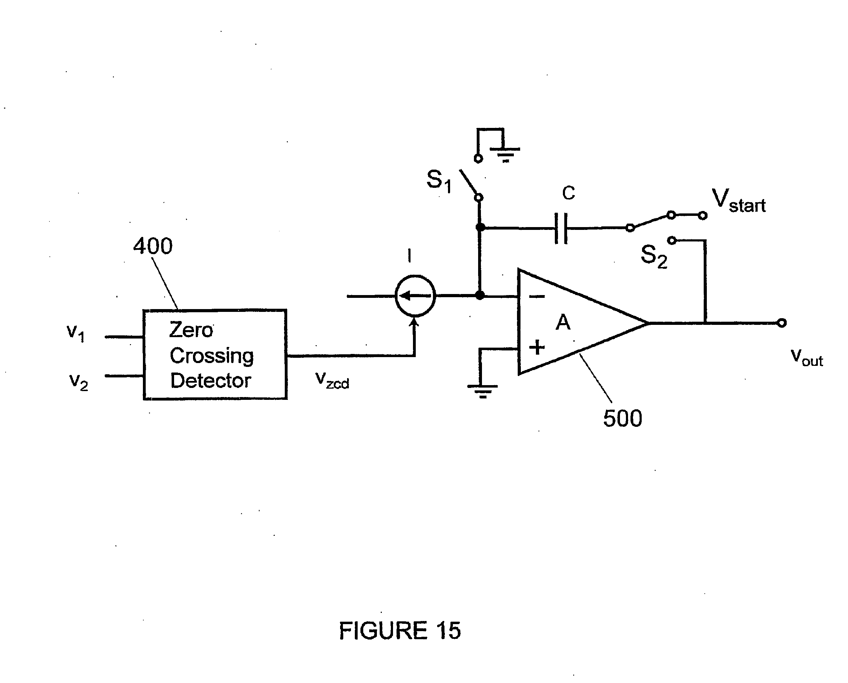

One embodiment of the present invention that provides a circuit that generates ramp waveforms with plurality of linear segments of varying slopes is illustrated in Figure 15. As illustrated in Figure 15, a sample-data circuit includes an amplifier **500** that preferably provides large open loop gain. A zero crossing detector **400** detects the condition when an input voltage **v₁** crosses another input voltage **v₂**, at which time the output signal **V_{zed}** changes, signaling the detection of zero-crossing.

It is noted that a continuous-time voltage comparator can be used as a zero crossing detector. It is further noted that the zero crossing detector **400** may have a non-zero threshold voltage, if desired. Thus, a voltage level detector can be employed instead.

As illustrated in Figure 15, before the start of the first segment of a ramp waveform generation, a capacitor **C** is precharged to a start voltage **Vₛₜₐᵣₜ** by turning a switch **S₁** ON and connecting a switch **S₂** to the upper position, the upper position being connected to start voltage **Vₛₜₐᵣₜ.** Next, the switch **S₁** is turned OFF, and the switch **S₂** is connected to the lower position. The capacitor **C** now provides negative feedback. In a single-slope operation as shown in Figure 5, current source **I** provides constant current. For a multi-slope operation as shown in Figures 8 and 11, the current source **I** is a variable current source, and set to one of a plurality of current levels **I₁.** The output voltage **vₒᵤₜ** is approximately a linear ramp given by **vₒᵤₜ=Vₛₜₐᵣₜ** + **I₁t/C.** In one embodiment, the current source **I** is implemented by a resistor connected to a constant voltage. In another embodiment, the current source I is implemented by a MOS transistor.

If **I₁** is positive, the resulting **vₒᵤₜ** is a positive-going ramp. In a multi-slope operation, when the output signal **v_{zed}** of the zero crossing detector **400** changes at time t=t₁, the value of the current source **I** is changed to the next value **I₂** in order to produce the next segment of the ramp. The output voltage **vₒᵤₜ** in the second segment is **Vₒᵤₜ=Vₛₜₐᵣₜ+ I₁t₁/C** + **I₂t/C.**

A negative-going second segment of the ramp can be generated by making **I₂** negative. More segments can be produced by changing the value of the current **I.** In this embodiment, a ramp waveform generator produces substantially constant slope within each segment regardless of the load condition.

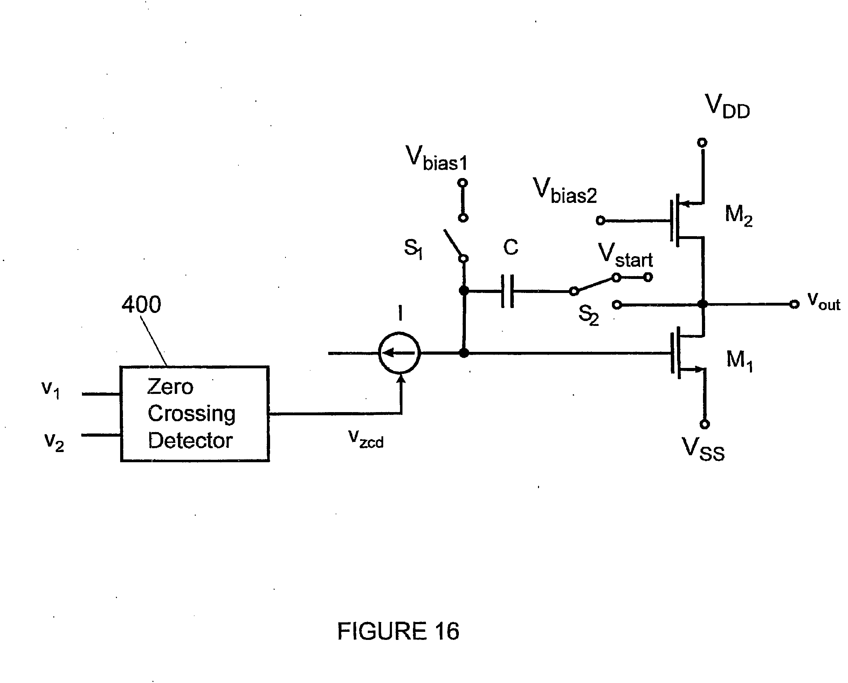

Figure 16 shows another embodiment of the present invention created with CMOS technology. The structure and the operation are similar to the embodiment illustrated and described with respect to Figure 15.

As illustrated in Figure 16, an amplifier includes MOS transistors **M₁** and **M₂.** A zero crossing detector **400** detects the condition when an input voltage **v₁** crosses another input voltage **v₂,** at which time the output signal **v_{zed}** changes, signaling the detection of a zero-crossing.

It is noted that a continuous-time voltage comparator can be used as a zero crossing detector. It is further noted that the zero crossing detector 400 may have a non-zero threshold voltage, if desired. Thus, a voltage level detector can be employed instead.

As illustrated in Figure 16, before the start of the first segment of a ramp waveform generation, a capacitor **C** is precharged by turning a switch **S₁** ON and connecting a switch **S₂** to the upper position, the upper position being connected to start voltage **Vₛₜₐᵣₜ.** This precharges the capacitor **C** to **Vₛₜₐᵣₜ - V_{bias1}.** The voltage **V_{bias1}** may be approximately the same as the gate voltage of **M₁**. Next, the switch **S₁** is turned OFF, and the switch **S₂** is connected to the lower position. The capacitor **C** now provides negative feedback. In a single-slope operation as shown in Figure 5, current source **I** provides constant current. For a multi-slope operation as shown in Figures 8 and 11, the current source **I** is a variable current source, and set to one of the plurality of current levels **I₁.** The output voltage **vₒᵤₜ** is approximately a linear ramp given by **vₒᵤₜ=Vₛₜₐᵣₜ** + **I₁t/C.** In one embodiment, the current source **I** is implemented by a resistor connected to a constant voltage. In another embodiment, the current source I is implemented by a MOS transistor.

If **I₁** is positive, the resulting **vₒᵤₜ** is a positive-going ramp. In a multi-slope operation, when the output signal **v_{zed}** of the zero crossing detector **400** changes at time t=t₁, the value of the current source **I** is changed to the next value **I₂** in order to produce the next segment of the ramp. The output voltage **vₒᵤₜ** is **vₒᵤₜ=Vₛₜₐᵣₜ + I₁t₁/C** + **I₂t/C.**

A negative-going second segment of the ramp can be generated by making **I₂** negative. More segments can be produced by changing the value of the current **I.** In this embodiment, a ramp waveform generator produces substantially constant slope within each segment regardless of the load condition.

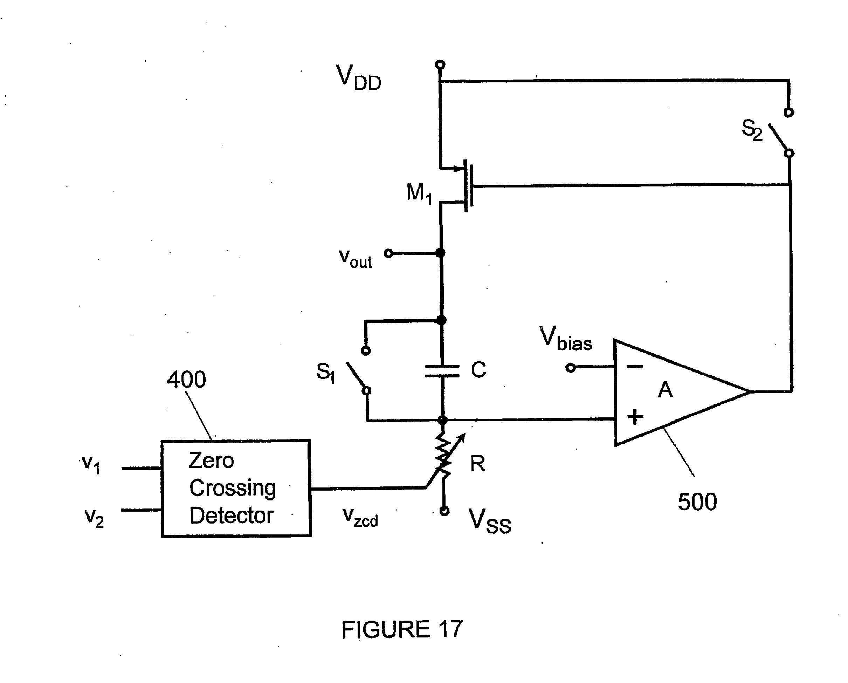

Figure 17 shows another embodiment of the present invention. As illustrated in Figure 17, a sample-data circuit includes a differential amplifier 500 that provides, preferably, a large open-loop gain. Before the start of the ramp generation, the switch **S₁** is closed, and a first value **R₁** of the resistor **R** is selected.

By the negative feedback through the transistor **M₁** and the resistor **R,** the voltage across the resistor **R** is maintained at **V_{bias}-Vₛₛ.** Thus, the current through the resistor is **I₁= (V_{bias}-V_{SS}) /R₁,** and the initial output voltage is **V_{bias}.**

Next, the switch **S₁** is opened. By the negative feedback through the transistor **M₁,** the capacitor **C,** and the resistor **R,** the voltage across **R** is still maintained at **V_{bias}** -Vss and the current through the resistor **R** at **I₁ =(V_{bias}-V_{SS})/R₁.** The capacitor **C** is charged by the current **I₁,** giving the output voltage **vₒᵤₜ=V_{bias}+I₁t/C=V_{bias}+(V_{bias} - V_{SS})t/R₁C.**

In a multi-slope operation, when the output signal **v_{zed}** of the zero crossing detector changes at time t=t₁, the value of the resistor **R** is changed to the next value R₂ in order to produce the next segment of the ramp. The output voltage **vₒᵤₜ** in the second segment is **vₒᵤₜ = V_{bias}+(V_{bias} -V_{SS})t₁/R₁C+(V_{bias} -V_{SS})t₂/R₂C.** More segments can be produced by further changing the value of the resistor **R**. In this embodiment, a ramp waveform generator produces substantially constant slope within each segment regardless of the load condition.

The embodiment of Figure 17 can generate multiple segments of a positive-going ramp waveform. The ramp can be stopped by turning the switch **S₂** ON, which cuts off the transistor **M₁.**

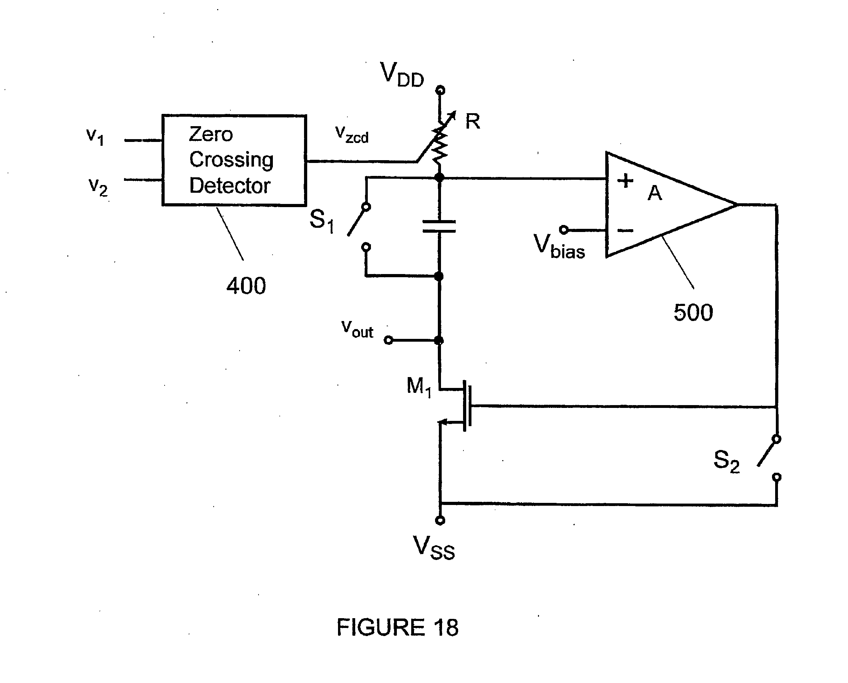

Figure 18 shows a complimentary embodiment of Figure 17. As illustrated in Figure 18, a sample-data circuit includes a differential amplifier **500** that provides, preferably, a large open-loop gain. Before the start of the ramp generation, the switch **S₁** is closed, and a first value R₁ of the resistor **R** is selected.

By the negative feedback through the transistor **M₁** and the resistor **R,** the voltage across the resistor **R** is maintained at **V_{bias}-VDD.** Thus, the current through the resistor is **I₁ = (V_{bias}-V_{DD})** /R₁, and the initial output voltage is **V_{bias}.**

Next, the switch **S₁** is opened. By the negative feedback through the transistor **M₁,** the capacitor **C**, and the resistor **R,** the voltage across **R** is still maintained at **V_{bias} -V_{DD}** and the current through the resistor **R** at **I₁**=(**V_{bias}-V_{DD}**)/R₁. The capacitor **C** is charged by the current **I₁,** giving the output voltage **Vₒᵤₜ=V_{bias}+I₁t/C=V_{bias}+(V_{bias} - V_{DD})**t**/R₁C.**

In multi-slope operation, when the output signal **v_{zed}** of the zero crossing detector changes at time t=t₁, the value of the resistor **R** is changed to the next value R₂ in order to produce the next segment of the ramp. The output voltage **vₒᵤₜ** in the second segment is **Vₒᵤₜ= V_{bias}+(V_{bias} -V_{DD})t₁/R₁C+(V_{bias} -V_{DD})t₂/R₂C.** Multiple segments of a negative-going ramp waveform can be produced by further changing the value of the resistor **R.** In this embodiment, a ramp waveform generator produces substantially constant slope within each segment regardless of the load condition.

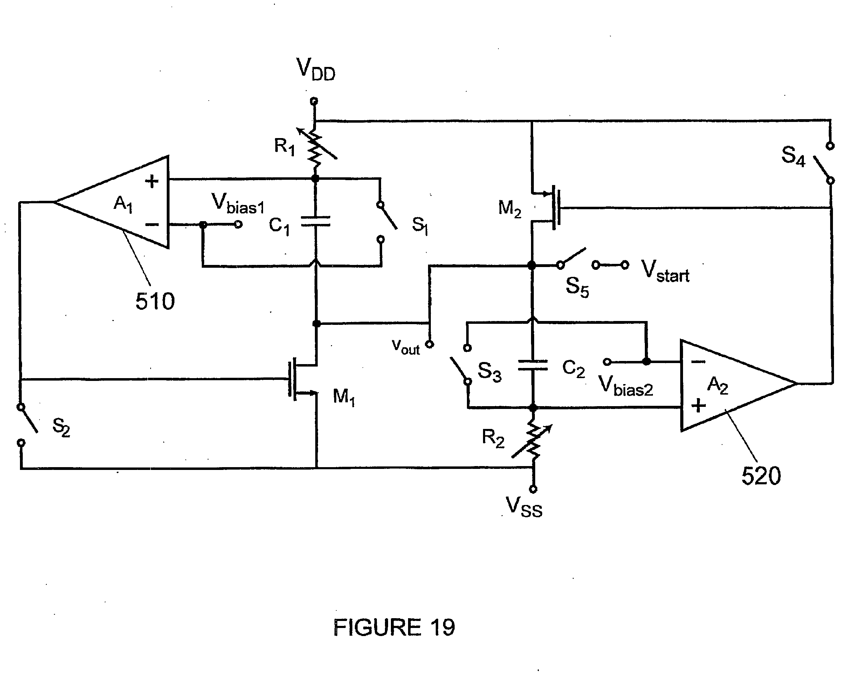

Both positive-going and negative-going segments can be generated by another embodiment, as illustrated by Figure 19. As illustrated by Figure 19, before the start of the first segment, switches **S₁, S₂, S₃,** and **S₅** are closed, and **S₄** is opened. This configuration precharges a capacitor **C₁** at **Vₛₜₐᵣₜ - V_{bias1}** and another capacitor **C₂** at **Vₛₜₐᵣₜ** - **V_{bias2},** setting the initial condition of the output voltage at **Vₛₜₐᵣₜ.**

A first value R₂(1) of the resistor **R₂** is selected. By the negative feedback through the transistor **M₂** and the resistor **R₂,** the voltage across **R₂** is maintained at **V_{bias2}-V_{SS}.** Thus, the current through the resistor is given by **I₁= (V_{bias2}-V_{SS})** / R₂(1).

The first segment starts by opening switches **S₃** and **S₅.** The capacitor **C₂** is charged by the current **I₁,** giving a positive-going ramp output voltage. Negative-going segments can be produced by turning switches **S₃** and **S₄** ON, and turning **S₁** and **S₂** OFF. In this embodiment, a ramp waveform generator produces substantially constant slope within each segment regardless of the load condition.

It is noted that since a zero crossing detector must detect the zero crossing preferably continuously, a continuous-time voltage comparator can be used as a zero-crossing detector.

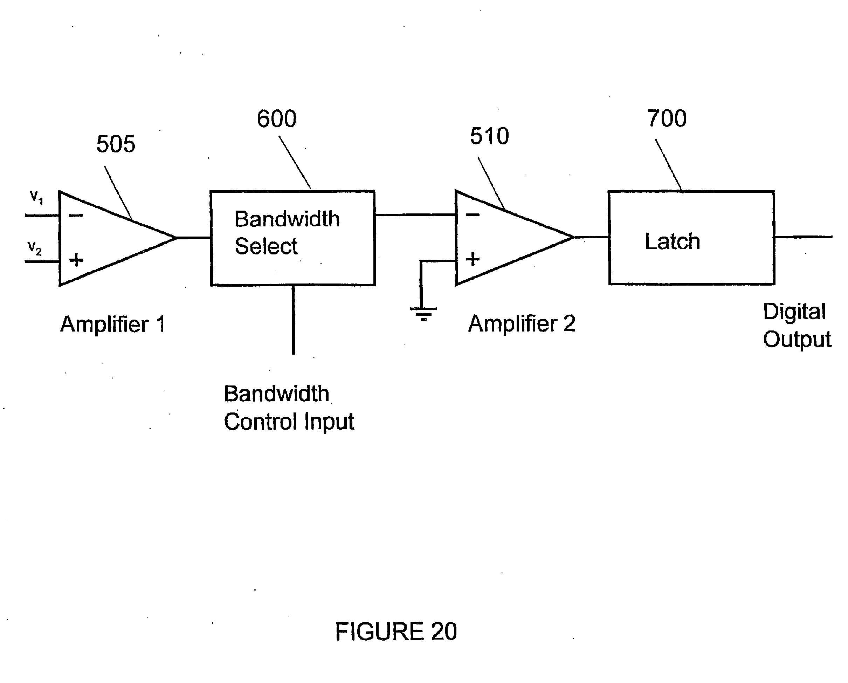

Figure 20 illustrates an embodiment of a continuous-time voltage comparator to be used in the present invention. As illustrated in Figure 20, the continuous-time comparator includes a first amplifier stage **505** that amplifies the difference between the two input voltages **v₁** and **v₂.**

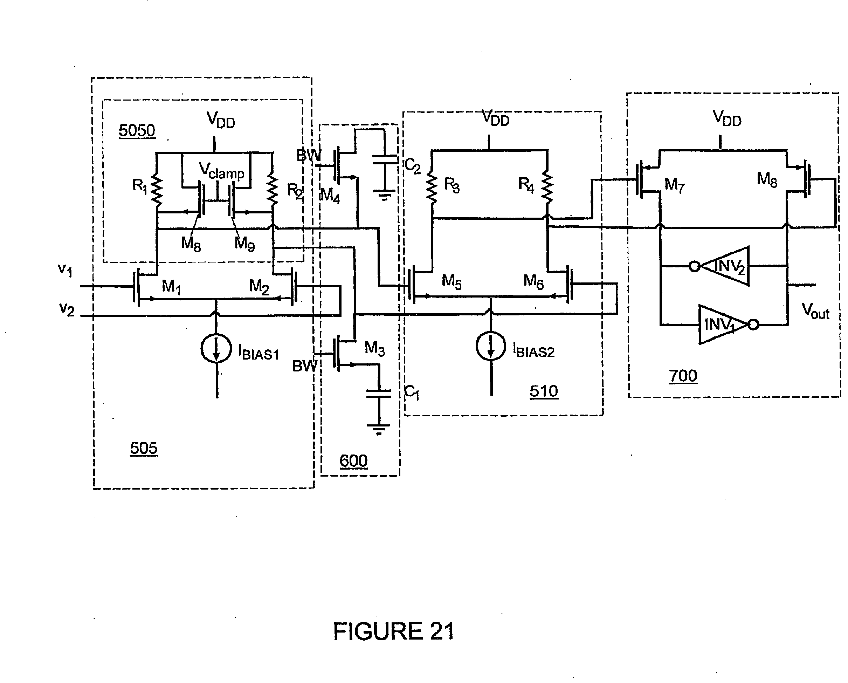

The first amplifier stage **505** includes a clamping circuit **5050,** as illustrated in Figure 21, wherein the clamping circuit **5050** includes transistors **M₈** and **M₉.** The clamping circuit **5050** limits the output voltage swing to shorten the delay. It is noted that a similar clamping circuit can be employed in other amplifier stages if desired.

As illustrated in Figure 20, the output of the amplifier **505** is connected to a bandwidth select circuit **600.** The output of the first amplifier stage is further amplified by a second amplifier stage **510.** A latch circuit **700** generates logic level output. It is noted that a Schmitt trigger-type circuit can be used as a continuous-time latch.

The bandwidth select circuit **600** provides different bandwidths depending on different segments of the ramp waveform. The zero crossing detection during the first segment can be a coarse detection, as the zero crossing detection during the first segment does not have to be very accurate. However, since the detection is made while the input to the detector is changing rapidly, the detection needs to be fast.

On the other hand, the zero crossing detection during the last segment in a given cycle determines the accuracy of the output voltage. Therefore, the bandwidth during the first segment can be designed to be high and progressively lower for detection in successive segments to reduce noise for accurate zero crossing detection.

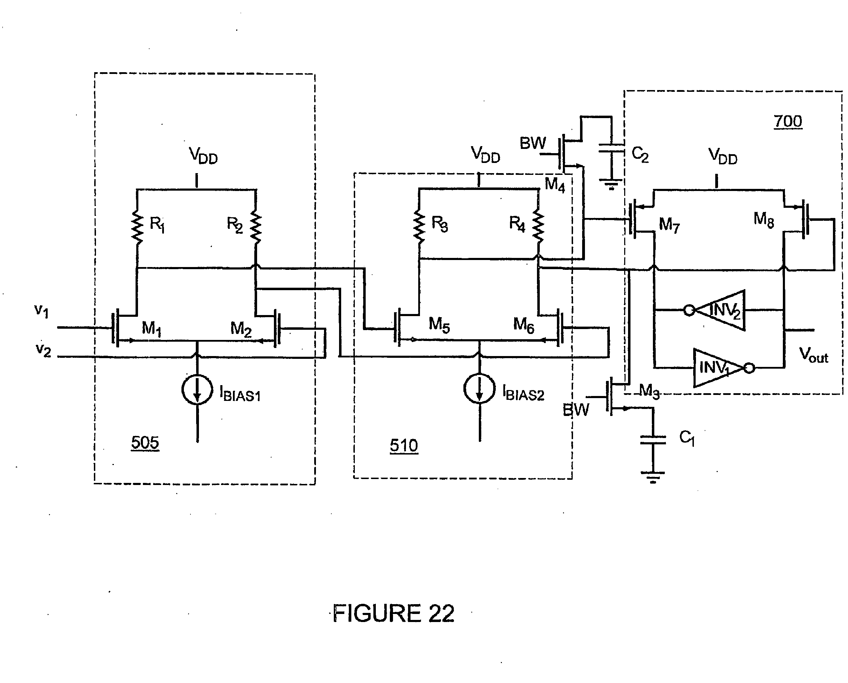

Since the mean-square value of noise is approximately proportional to bandwidth, the bandwidth is made lower during the later segments by the bandwidth select circuit. The bandwidth selection is made at the output of the first amplifier stage **505** by the input signal **BW,** as illustrated by Figure 21. Alternatively, the bandwidth selection can be made at the output of the second amplifier stage **510** as illustrated by Figure 22. Also, it is noted that the number of amplifier stages is increased in a high resolution operation.

An alternative method of bandwidth change is to control the bias currents **I_{bias1}** and/or **I_{bias2}** by the zero crossing detector instead of switching in or out the band-limiting capacitors **C₁** and **C₂.** The higher the bias currents of a stage, the higher the bandwidth of that stage becomes.

As noted above, Figure 21 illustrates another embodiment of a continuous-time voltage comparator to be used in the present invention. As illustrated in Figure 21, a first amplifier stage **505** includes transistors **M₁** and **M₂** and resistors **R₁** and **R₂.** A second amplifier stage **510** includes transistors **M₅** and **M₆** and resistors **R₃** and **R₄.**

It is noted that a clamping circuit that limits the output voltage swing can be employed to shorten the delay in the amplifier stages.

Since the effect of the noise from the second amplifier stage **510** is reduced by the voltage gain of the first stage **505,** a second stage bias current **I_{bias2}** can be made lower than a first stage bias current **I_{bias1}** in order to reduce power consumption.

As illustrated in Figure 21, a latch includes transistors **M₇** and **M₈** and inverters **Inv₁** and **Inv₂.** A bandwidth select circuit **600** includes switches **M₃** and **M₄** and capacitors **C₁** and **C₂**

For the zero crossing detection during the first segment where high speed is desired, the switches **M₃** and **M₄** are kept OFF. The bandwidth of the first amplifier stage **505** is determined by the resistors **R₁** and **R₂** and parasitic capacitance at the output of the first stage **505.**

For the zero crossing detection during the segments where low noise is necessary, the switches **M₃** are **M₄** are turned ON. The added capacitance from **C₁** and **C₂** at the outputs of the first stage **505** reduces the bandwidth, lowering the noise.

With nominally matched transistors and resistors, the detection threshold is zero. However, by varying either **R₁** or **R₂,** the detection threshold can be varied to cancel the effect of overshoot in each segment of the ramp.

Figure 22 illustrates another embodiment of a continuous-time voltage comparator to be used in the present invention. As illustrated in Figure 22, a first amplifier stage **505** includes transistors **M₁** and **M₂** and resistors **R₁** and **R₂.** A second amplifier stage **510** includes transistors **M₅** and **M₆** and resistors **R₃** and **R₄.**

It is noted that a clamping circuit that limits the output voltage swing can be employed to shorten the delay in the amplifier stages.

Since the effect of the noise from the second amplifier stage **510** is reduced by the voltage gain of the first stage **505,** a second stage bias current **I_{bias2}** can be made lower than a first stage bias current **I_{bias1}** in order to reduce power consumption.

As illustrated in Figure 22, a latch includes transistors **M₇** and **M₈** and inverters **Inv₁** and **Inv₂.** A bandwidth select circuit includes switches **M₃** and **M₄** and capacitors **C₁** and **C₂.**

For the zero crossing detection during the first segment where high speed is desired, the switches **M₃** and **M₄** are kept OFF. The bandwidth of the first amplifier stage **505** is determined by the resistors **R₁** and **R₂** and parasitic capacitance at the output of the first stage 505.

For the zero crossing detection during the segments where low noise is necessary, the switches **M₃** are **M₄** are turned ON. The added capacitance from **C₁** and **C₂** at the outputs of the second stage **510** reduces the bandwidth, lowering the noise.

With nominally matched transistors and resistors, the detection threshold is zero. However, by varying either **R₁** or **R₂,** the detection threshold can be varied. This is a useful feature to cancel the effect of overshoot in each segment of the ramp.

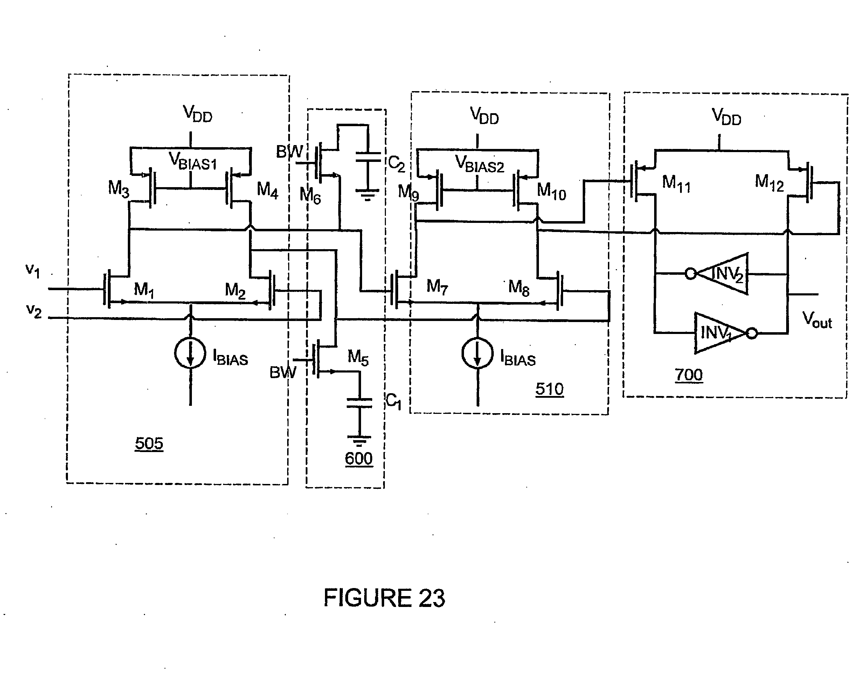

Figure 23 illustrates another embodiment of a continuous-time voltage comparator to be used in the present invention. As illustrated in Figure 23, a first amplifier stage **505** includes **M₁, M₂, M₃,** and **M₄.** A second amplifier stage **510** includes transistors **M₇, M₈, M₉,** and **M₁₀.** Bias voltages **V_{bias1}** and **V_{bias2}** are chosen to provide appropriate gain in the first and the second amplifier stages.

For small gain, the load transistors **M₃, M₄, M₉,** and **M₁₀** are biased in the triode region. If a large voltage gain is desired from the first stage amplifier 505, the load transistors **M₃** and **M₄** can be biased in the saturation region. In such cases, the voltage **V_{bias1}** is controlled by a common-mode feedback circuit.

It is noted that a clamping circuit, which limits the output voltage swing, can be utilized to shorten the delay in the amplifier stages.

Since the effect of the noise from the second amplifier stage 510 is reduced by the voltage gain of the first stage **505,** the second stage bias current **I_{bias2}** can be made lower than the first stage bias current **I_{bias1}** in order to reduce power consumption.

As illustrated in Figure 23, a latch includes transistors **M₁₁** and **M₁₂** and inverters **Inv₁** and **Inv₂.** A bandwidth select circuit includes switches **M₅** and **M₆** and capacitors **C₁** and **C₂.**

For the zero crossing detection during the first segment where high speed is desired, the switches **M₅** are **M₆** are kept OFF. The bandwidth of the first amplifier stage **505** is determined by bias voltages **V_{bias1}** and parasitic capacitance at the output of the first stage.

For the zero crossing detection during the segments where low noise is necessary, the switches **M₅** are **M₆** are turned ON. The added capacitance from **C₁** and **C₂** at the outputs of the first stage reduces the bandwidth, lowering the noise. With nominally matched transistors and resistors, the detection threshold is zero. However, by varying the gate voltages on **M₃** or **M₄** individually, the detection threshold can be varied to cancel the effect of overshoot in each segment of the ramp.

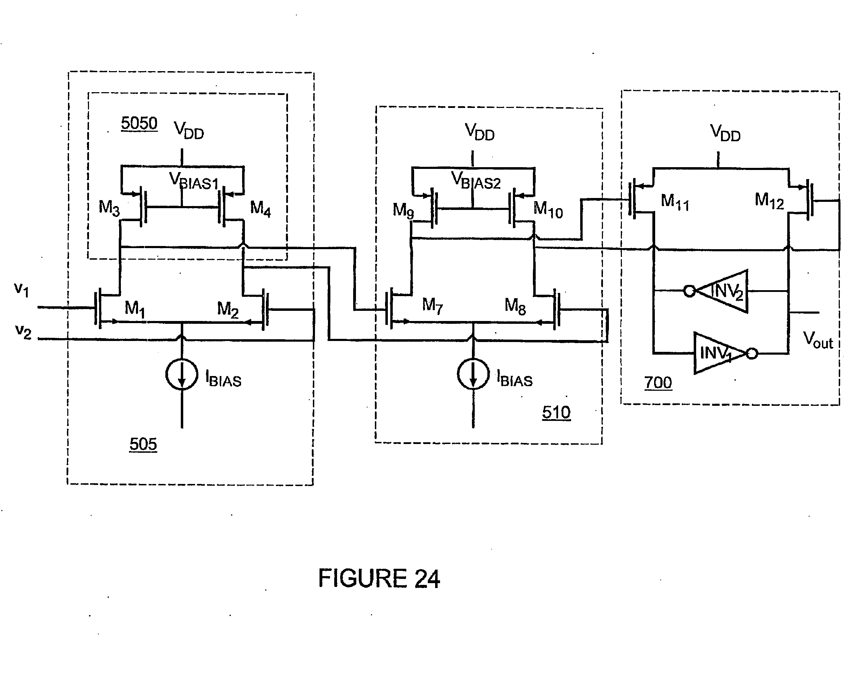

Figure 24 illustrates another embodiment of a continuous-time voltage comparator to be used in the present invention. As illustrated in Figure 24, a first amplifier stage **505** includes transistors **M₁, M₂, M₃,** and **M₄.** A second amplifier stage **510** includes transistors **M₇, M₈, M₉,** and **M₁₀.**

It is noted that a clamping circuit, which limits the output voltage swing, can be utilized to shorten the delay in the amplifier stages.

Bias voltages **V_{bias1}** and **V_{bias2}** are controlled together with transistor sizes and bias currents for appropriate gain and bandwidth in the first and the second amplifier stages. For small gain and large bandwidth, the load transistors **M₃, M₄, M₉,** and **M₁₀** are biased in the triode region.

Bandwidth can be reduced and gain made larger by raising one or both of the bias voltages. Alternatively, bandwidth can be reduced and gain made larger by making bias current **I_{bias1}** lower. If larger voltage gain and correspondingly low bandwidth is desired, the load transistors **M₃** and **M₄** can be biased in the saturation region. In such cases, the voltage **V_{bias1}** is controlled by a common-mode feedback circuit.

With nominally matched transistors and resistors, the detection threshold is zero. However, by varying the gate voltages on **M₃** or **M₄** individually, the detection threshold can be varied to cancel the effect of overshoot in each segment of the ramp.

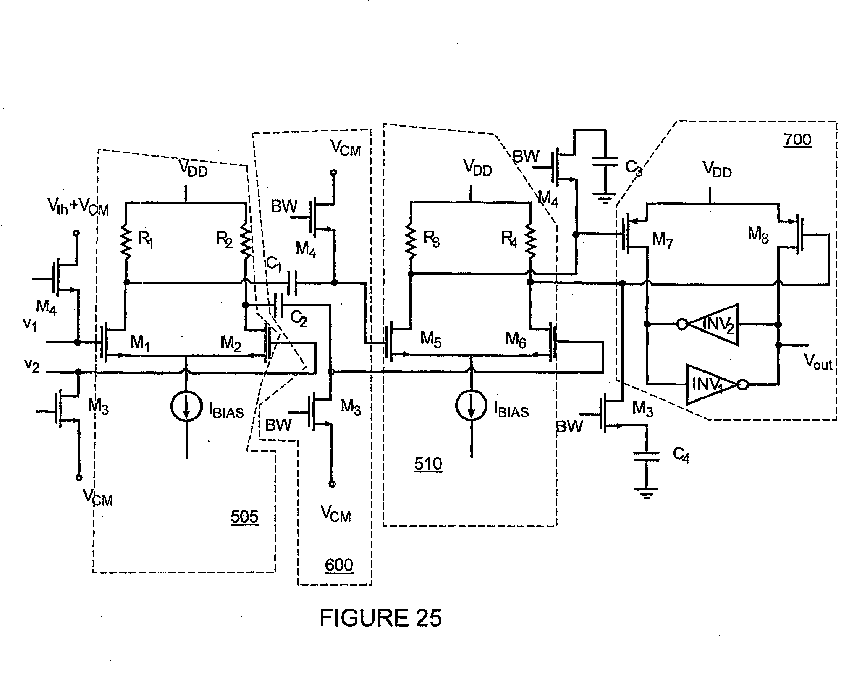

Figure 25 illustrates another embodiment of a continuous-time voltage comparator with offset cancellation to be used in the present invention. As illustrated in Figure 25, a first amplifier stage **505** includes transistors **M₁** and **M₂** and resistors **R₁** and **R₂.** A second amplifier stage **510** includes transistors **M₅** and **M₆** and resistors **R₃** and **R₄.**

It is noted that a clamping circuit, which limits the output voltage swing, can be utilized to shorten the delay in the amplifier stages.

Since the effect of the noise from the second amplifier stage **510** is reduced by the voltage gain of the first stage **505,** a second stage bias current **I_{bias2}** can be made lower than a first stage bias current **I_{bias1}** in order to reduce power consumption.

As illustrated in Figure 25, a latch includes transistors **M₇** and **M₈** and inverters **Inv₁** and **Inv₂.** A bandwidth select circuits include switches **M₃** and **M₄** and capacitors **C₁** and **C₂.**

During the offset cancellation phase, switches **M₃** and **M₄** are closed so that the system common-mode voltage **V_{CM}** can be applied to inputs, **v₁** and **v₂,** and the desired threshold **Vₜₕ** is added to the upper input **v₁.** The offset of the first stage amplifier **505** plus the desired threshold **Vₜₕ** is amplified and output from the first stage **505.** This voltage is differentially sampled on capacitors **C₁** and **C₂.**

Next, switches **M₃** and **M₄** are opened, and the comparator operates normally. The voltage sampled on **C₁** and **C₂** counteracts with the offset in the first amplified stage canceling the effect and provides accurate detection threshold of **Vₜₕ.**

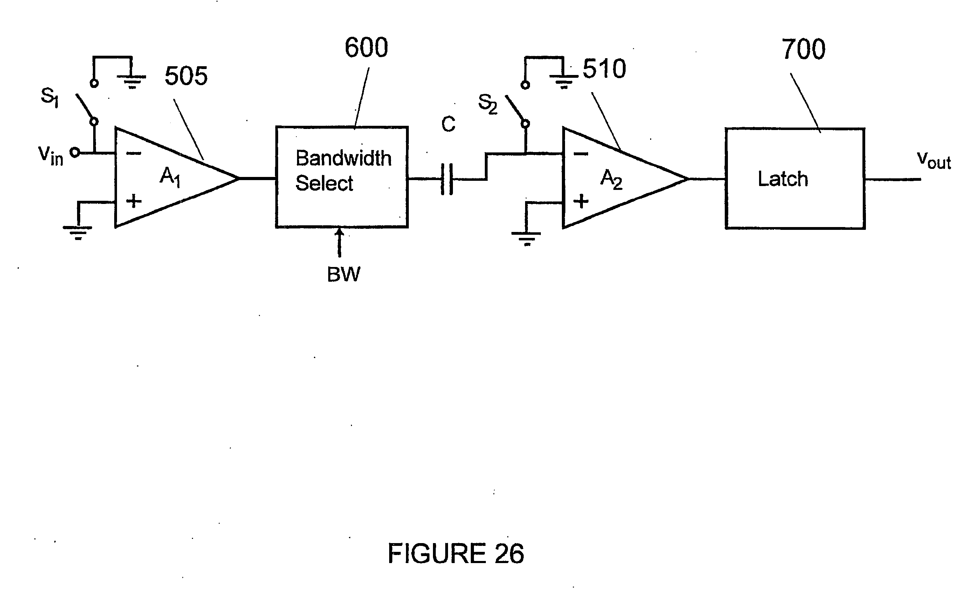

Figure 26 illustrates another embodiment of a continuous-time voltage comparator with offset cancellation to be used in the present invention. As illustrated in Figure 26, an offset cancellation is included to cancel the offset voltage due to device mismatches in the first stage amplifier.

It is noted that similar offset cancellation method can be applied to other amplifier stages if greater precision is desired.

Figure 26 illustrates an open loop offset cancellation method; however, it is noted that other methods of offset cancellation can be utilized

During the offset cancellation phase, switches **S₁** and **S₂** are closed so that the inputs to the amplifiers **505** and **510** are pulled to ground. The offset of the first stage amplifier **505** is amplified and shows up at the output of the first stage. This voltage is sampled on a capacitor **C.** Next, switches **S₁** and **S₂** are opened, and the comparator operates normally. The voltage sampled on **C** counteracts with the offset in the first amplified stage canceling the effect of the offset.

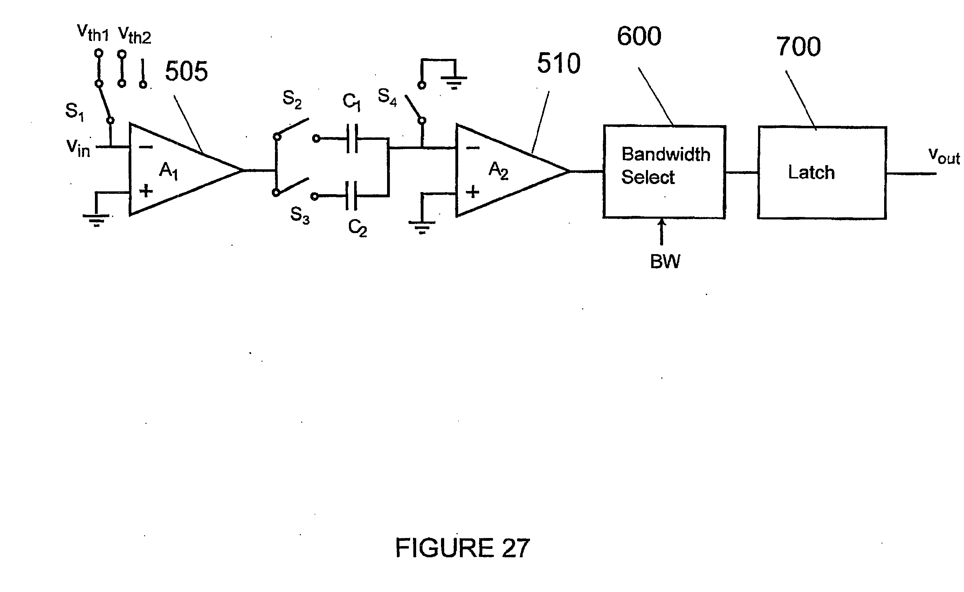

Figure 27 illustrates another embodiment of a zero crossing detector. As illustrated in Figure 27, a zero crossing detector includes plurality of threshold voltages. The circuit in Figure 27 provides two different detection thresholds although more thresholds can be introduced as desired.

A first voltage **Vₜₕ₁** is first applied to the input of the first stage amplifier **505** by throwing the switch **S₁** to a first position. Switches **S₂** and **S₄** are closed to sample the output voltage of the first stage amplifier **505.** The switch **S₄** is first opened, and then **S₂** is opened.

Next, a second voltage **Vₜₕ₂** is first applied to the input of the first stage amplifier 505 by throwing the switch **S₁** to a second position. Switches **S₃** and **S₄** are closed to sample the output voltage of the first stage amplifier **505.** The switch **S₄** is first opened, and then **S₃** is opened.

The zero crossing detector is then operated normally by throwing the switch **S₁** to the third (open) position. With **S₂** closed, the first detection threshold **Vₜₕ₁** is selected, and with **S₃** closed, the second detection threshold **Vₜₕ₂** is selected. Each detection threshold can be adjusted to cancel the effect of overshoot during each segment.

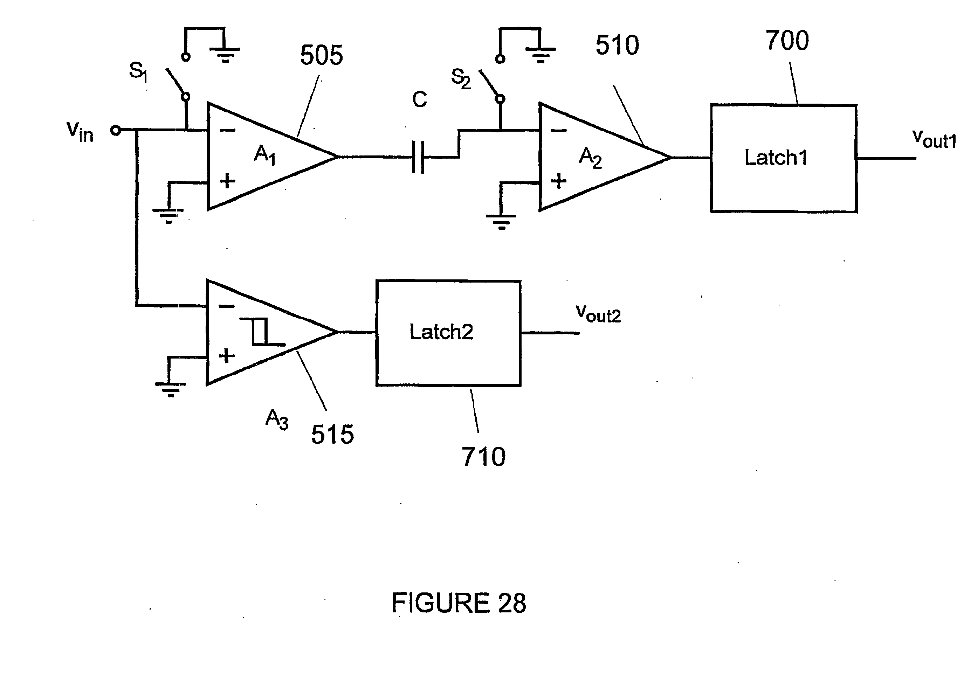

Figure 28 illustrates another embodiment of a zero crossing detector. As illustrated in Figure 28, a zero crossing detector includes a plurality of zero-crossing detectors. A first zero-crossing detector is preferably fast, but the first zero-crossing detector is not necessarily very accurate. On the other hand, a second zero crossing detector is preferably low noise and high accuracy, but the second zero crossing detector is not necessarily fast.

The first detector is activated during the first segment, whereas the second detector is activated in the second segment. The detection threshold of each detector can be adjusted to cancel the effect of overshoot during each segment.

As illustrated in Figure 28, the first zero crossing detector includes a first stage amplifier **505,** a second stage amplifier **510,** and a first latch **700.** The second zero crossing detector includes a third amplifier 515 and a second latch 710.

For fast speed, the third amplifier **515** is a Schmitt trigger type with positive feedback. The detection thresholds for each zero crossing detector are optimized separately to cancel the effect of the overshoot. The bandwidth of the first detector is made lower than that of the second detector for lower noise.

## Claims

1. A zero-crossing detector based circuit **(Fig. 10)** comprising;
a waveform generator **(20)** to produce a predetermined waveform;
a zero-crossing detector **(300)** operatively coupled to said waveform generator, said zero-crossing detector **(Fig. 20)** comprising;
an amplifier stage **(505);** and
a bandwidth controller **(600)** operatively connected to said amplifier stage;
said bandwidth controller providing a variable bandwidth for the zero-crossing detector circuit so that the zero-crossing detector circuit provides a first level of zero-crossing detection coarseness during a first period of time and a second level of zero-crossing detection coarseness during a second period of time, said first level of zero-crossing detection coarseness being coarser than said second level of zero-crossing detection coarseness.

2. The zero-crossing detector based circuit as claimed in claim 1, wherein said amplifier stage **(505,** Fig. **21)** includes a clamping circuit **(5050)** to shorten a delay in the amplifier stage.

3. The zero-crossing detector based circuit as claimed in claim 1, wherein said bandwidth controller **(600, Fig. 21)** comprises a capacitor and a switch.

4. The zero-crossing detector based circuit as claimed in claim 1, wherein said bandwidth controller **(600)** provides said variable bandwidth in response to said predetermined waveform.

5. The zero-crossing detector based circuit as claimed in claim 1, further comprising a plurality of bandwidth controllers, each bandwidth controller being operatively connected to said amplifier stage.

6. The zero-crossing detector based circuit as claimed in claim 1 wherein said bandwidth controller includes a MOS transistor **(M₃, M₄, M₉, or M₁₀, Fig. 24),** said bandwidth controller controlling a bias voltage **V_{bias1} or V_{bias2}** operatively connected said MOS transistor.

7. The zero-crossing detector based circuit as claimed in claim 1 wherein said bandwidth controller includes a variable current source **(I_{bias}, Fig. 24)** said bandwidth controller controlling the current level of the variable current source.

## Patentansprüche

1. Schaltung (Fig. 10) auf Grundlage eines Nulldurchgangsdetektors, umfassend:
einen Wellenformgenerator (20) zum Erzeugen einer vorgegebenen Wellenform;
einen Nulldurchgangsdetektor (300), der wirksam mit dem besagten Wellenformgenerator gekoppelt ist, wobei der besagte Nulldurchgangsdetektor (Fig. 20) umfasst:
eine Verstärkerstufe (505); und
eine Bandbreitensteuerung (600), die wirksam mit der besagten Verstärkerstufe verbunden ist;
wobei die besagte Bandbreitensteuerung eine veränderliche Bandbreite für die Nulldurchgangsdetektorschaltung vorsieht, sodass die Nulldurchgangsdetektorschaltung ein erstes Nulldurchgangserkennungs-Grobheitsniveau während eines ersten Zeitraums und ein zweites Nulldurchgangserkennungs-Grobheitsniveau während eines zweiten Zeitraums vorsieht, wobei das besagte erste Nulldurchgangserkennungs-Grobheitsniveau gröber ist als das besagte zweite Nulldurchgangserkennungs-Grobheitsniveau.

2. Schaltung auf Grundlage eines Nulldurchgangsdetektors nach Anspruch 1, wobei die besagte Verstärkerstufe (505, Fig. 21) eine Klemmschaltung (5050) enthält, um eine Verzögerung in der Verstärkerstufe zu verkürzen.

3. Schaltung auf Grundlage eines Nulldurchgangsdetektors nach Anspruch 1, wobei die besagte Bandbreitensteuerung (600, Fig. 21) einen Kondensator und einen Schalter umfasst.

4. Schaltung auf Grundlage eines Nulldurchgangsdetektors nach Anspruch 1, wobei die besagte Bandbreitensteuerung (600) die besagte veränderliche Bandbreite als Antwort auf die besagte vorgegebene Wellenform vorsieht.

5. Schaltung auf Grundlage eines Nulldurchgangsdetektors nach Anspruch 1, weiter umfassend eine Vielzahl von Bandbreitensteuerungen, wobei jede Bandbreitensteuerung wirksam mit der besagten Verstärkerstufe verbunden ist.

6. Schaltung auf Grundlage eines Nulldurchgangsdetektors nach Anspruch 1, wobei die besagte Bandbreitensteuerung einen MOS-Transistor enthält (M₃, M₄, M₉, oder M₁₀, Fig. 24), wobei die besagte Bandbreitensteuerung eine Vorspannung V_{bias1} oder V_{bias2} steuert, die wirksam mit dem besagten MOS-Transistor verbunden ist.

7. Schaltung auf Grundlage eines Nulldurchgangsdetektors nach Anspruch 1, wobei die besagte Bandbreitensteuerung eine veränderliche Stromquelle enthält (I_{bias}, Fig. 24), wobei die besagte Bandbreitensteuerung den Strompegel der veränderlichen Stromquelle steuert.

## Revendications

1. Circuit basé sur un détecteur de passage par zéro (fig. 10), comprenant :
un générateur de formes d'onde (20) pour produire une forme d'onde prédéterminée ;
un détecteur de passage par zéro (300) fonctionnellement couplé avec ledit générateur de formes d'onde, ledit détecteur de passage par zéro (fig. 20) comprenant :
un étage amplificateur (505) ; et
un contrôleur de la largeur de bande (600) fonctionnellement connecté avec ledit étage amplificateur ;
ledit contrôleur de largeur de bande fournissant une largeur de bande variable pour le circuit à détecteur de passage par zéro, de telle sorte que le circuit à détecteur de passage par zéro fournisse un premier niveau de grossièreté de détection à passage par zéro durant une première période de temps et un second niveau de grossièreté de détection à passage par zéro durant une seconde période de temps, ledit premier niveau de grossièreté de détection à passage par zéro étant plus grossier que ledit second niveau de grossièreté de détection à passage par zéro.

2. Circuit basé sur un détecteur de passage par zéro selon la revendication 1, dans lequel ledit étage amplificateur (505, fig. 21) comprend un circuit de clampage (5050) pour raccourcir un retard dans l'étage amplificateur.

3. Circuit basé sur un détecteur de passage par zéro selon la revendication 1, dans lequel ledit contrôleur de largeur de bande (600, fig. 21) comprend un condensateur et un commutateur.

4. Circuit basé sur un détecteur de passage par zéro selon la revendication 1, dans lequel ledit contrôleur de largeur de bande (600) fournit ladite largeur de bande variable en réponse à ladite forme d'onde prédéterminée.

5. Circuit basé sur un détecteur de passage par zéro selon la revendication 1, comprenant en outre une multitude de contrôleurs de largeur de bande, chaque contrôleur de largeur de bande étant fonctionnellement connecté audit étage amplificateur.

6. Circuit basé sur un détecteur de passage par zéro selon la revendication 1, dans lequel ledit contrôleur de largeur de bande comprend un transistor MOS (M₃, M₄, M₉, ou M₁₀, fig. 24), ledit contrôleur de largeur de bande contrôlant une tension de polarisation V_{bias1} ou V_{bias2} fonctionnellement connectée avec ledit transistor MOS.

7. Circuit basé sur un détecteur de passage par zéro selon la revendication 1, dans lequel ledit contrôleur de largeur de bande comprend une source de courant variable (I_{bias}, fig. 24), ledit contrôleur de largeur de bande contrôlant le niveau d'intensité de courant de la source de courant variable.
